# EUROPEAN PATENT APPLICATION

(11) **EP 4 852 324 A1**
(43) Date of publication of application: **09.12.2026**
(21) Application number: 25180971.1
(22) Date of filing: 05.06.2025
(51) Int. Cl.: H03L 7/099, H03K 3/03

(54) **OSCILLATOR DEVICE AND METHOD FOR INPUT INJECTION SPUR REDUCTION**

(71) Applicant: Stichting IMEC Nederland, 5656 AE Eindhoven (NL)
(72) Inventor: Xu, Zule, 5706 PP Helmond (NL); Mateman, Paul, 6566 ER Millingen a/d Rijn (NL)
(74) Representative: Roth, Sebastian

(57) **Abstract**

An oscillator device (100) is provided for input injection spur reduction. The oscillator device comprises at least two coupled oscillators (101, 102) configured to form at least one signal path (103), and at least one input arrangement (104) operably coupled to the at least one signal path (103) at one oscillator (101) of the at least two coupled oscillators (101, 102). The Oscillator device further comprises at least one output terminal (105) operably coupled to the at least one signal path (103) at the other oscillator (102) of the at least two coupled oscillators (101, 102). Moreover, the oscillator device comprises at least one capacitive element (106) coupled between the at least one input arrangement (104) and the at least one output terminal (105), and in parallel with the at least one signal path (103). In this regard, the at least one capacitive element (106) in conjunction with the at least one signal path (103) being configured to form a lowpass filter between the at least one input arrangement (104) and the at least one output terminal (105).

## Description

### TECHNICAL FIELD OF THE INVENTION

The invention relates to the input injection spur reduction, especially to the input injection spur filtering for injection-locked oscillators.

### BACKGROUND OF THE INVENTION

Generally, injection locking is a useful technique to reduce an oscillator's phase noise, such as a ring oscillator's phase noise. For example, the document US 2002/0039039 A1 discloses an injection locked frequency multiplier that utilizes a ring oscillator comprising an even number of phase shifting phases. However, the injection locking technique, especially for ring oscillators, may lead to high injection spurs, which may degrade the spectrum purity.

Accordingly, an object of the invention is to provide an oscillator device, a phase-locked loop (PLL), and a method for input injection spur reduction and/or filtering in order to overcome the above-mentioned limitations.

### SUMMARY OF THE INVENTION

The object of the invention is achieved by the solution provided in the enclosed independent claims. Advantageous implementations of the invention are further defined in the dependent claims.

According to a first aspect of the invention, an oscillator device for input injection spur reduction is provided. The oscillator device comprises at least two coupled oscillators configured to form at least one signal path. In addition, the oscillator device comprises at least one input arrangement operably coupled to the at least one signal path at one oscillator of the at least two coupled oscillators.

The oscillator device further comprises at least one output terminal operably coupled to the at least one signal path at the other oscillator of the at least two coupled oscillators. Moreover, the oscillator device comprises at least one capacitive element coupled between the at least one input arrangement and the at least one output terminal, and in parallel with the at least one signal path.

In this regard, the at least one capacitive element in conjunction with the at least one signal path being configured to form a low-pass filter between the at least one input arrangement and the at least one output terminal.

Advantageously, the components of the signal path, especially the oscillator components such as inverters, and the capacitive element form a negative feedback, which behaves as a low-pass filter that may regularize or smooth out any abrupt waveform change, as outputted from the output terminal, at the injection moment of the injection input, as inputted by the input arrangement.

Preferably, the at least one input arrangement is configured to input at least one injection signal for injection locking the at least two coupled oscillators. In this regard, the at least one injection signal comprises or is a periodic signal comprising a frequency corresponding to an oscillation frequency of the at least two coupled oscillators.

Additionally or alternatively, the periodic signal may comprise a frequency corresponding to the harmonics of the oscillation frequency and/or the sub-harmonics of the oscillation frequency of the at least two coupled oscillators.

Preferably, an input phase at the at least one input arrangement and an output phase at the at least one output terminal are adjacent phases, i.e., the phase difference between the outputs of consecutive stages in the oscillator loop, of the at least two coupled oscillators.

Preferably, each oscillator of the at least two coupled oscillators comprises or is a ring oscillator. In this regard, the ring oscillator comprises or is a three-stage ring oscillator.

Alternatively, the ring oscillator may comprise any odd number of stages, i.e., inverting stages.

Preferably, the at least one signal path comprises an odd number of inverters in series, preferably three inverters in series. In this regard, the inverters are complementary metal-oxide semiconductor, CMOS, inverters.

Preferably, the at least one capacitive element is configured to form the low-pass filter between the at least one input arrangement and the at least one output terminal as a low-pass transconductor-capacitor, Gm-C, filter corresponding to the transconductance, i.e., the ratio of the change in current at the output terminal to the change in the voltage at the input terminal, of the inverters of the at least one signal path and to the capacitance of the at least one capacitive element.

Advantageously, the odd number of inverters in series, particularly the three series inverters of the signal path and the capacitive element form a negative feedback which behaves as the Gm-C low-pass filter, especially to filter out the timing error that may result from the input injection spurs due to the abrupt waveform change at the injection moment.

Preferably, the at least one capacitive element comprises or is a wiring capacitor, i.e., a fringe capacitor. Advantageously, the desired capacitance can be achieved in a limited space, which for example minimizes the footprint of the CMOS circuit.

Preferably, the oscillator device comprises a number of N coupled oscillators being directly coupled in a cascade formation, where N is an even number.

In this regard, the number of N coupled oscillators comprise a number of 2*N phases, wherein a number of N/2 input arrangements being coupled to the odd phases of the number of 2*N phases, and, a number of N/2 output terminals being coupled to the even phases of the number of 2*N phases.

Moreover, each of the adjacent phases of the number of 2*N phases being coupled via the at least one capacitive element.

According to a second aspect of the invention, a phase-locked loop (PLL) is provided that comprises an oscillator device according to the first aspect of the invention.

According to a third aspect of the invention, a method is provided for input injection spur reduction. The method comprises the steps of forming at least one signal path via at least two coupled oscillators, coupling at least one input arrangement to the at least one signal path at one oscillator of the at least two coupled oscillators, coupling at least one output terminal to the at least one signal path at the other oscillator of the at least two coupled oscillators, and coupling at least one capacitive element between the at least one input arrangement and the at least one output terminal, and in parallel with the at least one signal path.

In this regard, the at least one capacitive element in conjunction with the at least one signal path form a low-pass filter between the at least one input arrangement and the at least one output terminal.

It is to be noted that the PLL according to the second aspect and the method according to the third aspect correspond to the system according to the first aspect and its implementation forms. Accordingly, the PLL of the second aspect and the method of the third aspect may have corresponding implementation forms.

### BRIEF DESCRIPTION OF THE DRAWINGS

Exemplary embodiments of the invention are now further explained with respect to the drawings by way of example only, and not for limitation. In the drawings:
- Fig. 1: shows a first exemplary embodiment of the oscillator device according to the first aspect of the invention;
- Fig. 2: shows a second exemplary embodiment of the oscillator device according to the first aspect of the invention;
- Fig. 3: shows a third exemplary embodiment of the oscillator device according to the first aspect of the invention;
- Fig. 4: shows an exemplary block of the oscillator device of Fig. 3;
- Fig. 5A: shows an exemplary representation of two adjacent phases, injection ripple, and filtered waveform of the oscillator block of Fig. 4;
- Fig. 5B: shows a simulation result for multiple phases of the oscillator block of Fig. 4;
- Fig. 6: shows a simulation result of injection spurs for multiple phases of the oscillator block of Fig. 4;
- Fig. 7: shows an exemplary embodiment of the PLL according to the second aspect of the invention; and
- Fig. 8: shows an exemplary embodiment of the method according to the third aspect of the invention.

### DETAILED DESCRIPTION OF THE PREFERRED EMBODIMENTS

Reference will now be made in detail to the embodiments of the present invention, examples of which are illustrated in the accompanying drawings. However, the following embodiments of the present invention may be variously modified and the range of the present invention is not limited by the following embodiments.

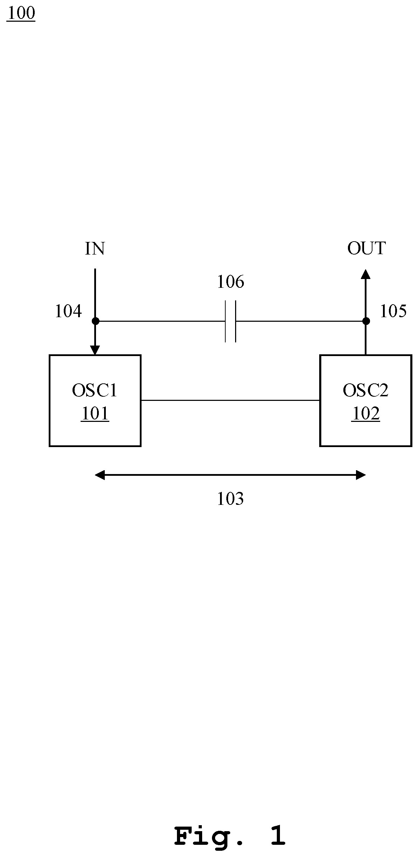

In Fig. 1, a first exemplary embodiment of the oscillator device 100 according to the first aspect of the invention is illustrated. The oscillator device 100 comprises a first oscillator (OSC1) 101 and a second oscillator (OSC2) 102. In this regard, the first oscillator 101 and the second oscillator 102 are coupled together in a cascade formation.

The coupling of the first oscillator 101 and the second oscillator 102 is therefore forms a signal path 103 particularly comprising one or more oscillator elements, e.g., inverters, of the first oscillator 101 and one or more oscillator elements, e.g., inverters, of the second oscillator 102.

In addition, the oscillator device 100 comprises an input arrangement (IN) 104 operably coupled to the first oscillator 101, especially to the signal path 103 at the first oscillator 101. The input arrangement 104 is configured to input an injection signal or pulse for injection locking the first oscillator 101 and the second oscillator 102, i.e., to lock the first oscillator 101 and/or the second oscillator 102 to the frequency of the injection signal, which corresponds to the oscillation frequency and/or the sub-harmonics of the oscillation frequency of the first oscillator 101 and/or the second oscillator.

Furthermore, the oscillator device 100 comprises an output terminal (OUT) or node 105 operably coupled to the second oscillator 102, especially to the signal path 103 at the second oscillator 102. In other words, the injection signal is injected at the first oscillator 101 and the output, e.g., phase output, is outputted from the second oscillator 102.

Moreover, the oscillator device 100 comprises a capacitive element or capacitor 106 coupled between the input arrangement 104 and the output terminal 105, and also in parallel to the signal path 103, i.e., in parallel to the components, e.g., inverters, of the signal path 103. Preferably, the capacitor 106 is a wiring capacitor or a fringe capacitor, e.g., realized with the fringe capacitance of the signal routings.

As such, the capacitor 106 in conjunction with the signal path 103, i.e., in conjunction with the components, e.g., inverters, of the signal path 103 form a low-pass filter between the input arrangement 104 and the output terminal 105 in order to regularize or smooth out any abrupt waveform change as outputted from the output terminal 105 at the injection moment of the injection input as inputted by the input arrangement 104.

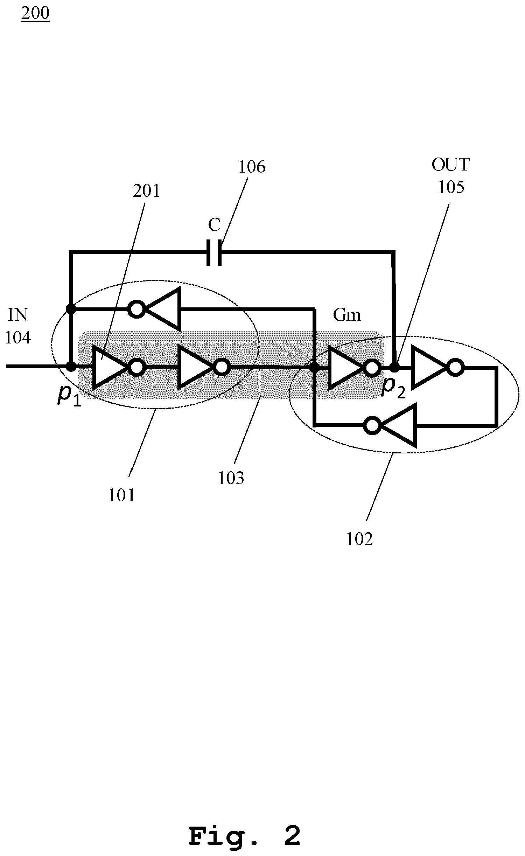

In Fig. 2, a second exemplary embodiment of the oscillator device 200 according to the first aspect of the invention is illustrated. In this example, the first oscillator 101 and the second oscillator 102 are three-stage ring oscillators, i.e., comprising three inverters in a ring formation.

It is to be noted that the invention is not limited to the number of stages illustrated in this example, and the oscillators 101, 102 may comprise any odd number of inverter stages.

In this example, the first oscillator 101 and the second oscillator 102 are cascaded together to form the signal path 103 that comprises a total of three inverters 201 in series, where two of the three inverters are the components of the first oscillator 101 and the other inverter is the component of the second oscillator 102.

In this example, the input arrangement 104 is coupled to the signal path 103 (phase P1) at the first oscillator 101 and the output terminal 105 is coupled to the signal path 103 (phase P2) at the second oscillator 102.

Furthermore, the capacitor 106 is coupled between the input arrangement 104 (phase P1) and the output terminal 105 (phase P2), and in parallel to the signal path 103, particularly in parallel to the three series inverters 201 of the signal path 103.

Accordingly, the odd number of inverters 201 in series, particularly the three series inverters 201 of the signal path 103 and the capacitor 106 form a negative feedback, i.e., between the phases P1 and P2, which behaves as a Gm-C low-pass filter, which is capable to filter out the timing error that may result from the input injection spurs due to the abrupt waveform change at the injection moment.

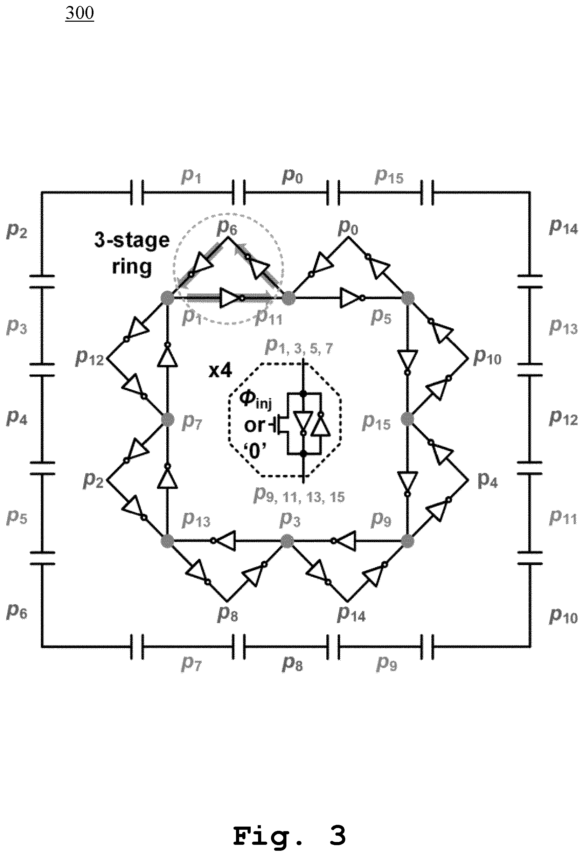

In Fig. 3, a third exemplary embodiment of the oscillator device 300 according to the first aspect of the invention is illustrated. In this example, the oscillator device 300 comprises eight ring oscillators in a cascade formation, each of the eight ring oscillators is a three stage ring oscillator, i.e., comprising three inverters in a ring formation.

In this example, sixteen possible phases P0-P15 are realized, where the phases P0-P15 are also coupled through a respective capacitor, i.e., a total of sixteen capacitors, which regulates the phase relationship and forms a Gm-C low-pass filter together with the inverters of the respective ring oscillator, as described before.

In this example, the input arrangement 104, which comprises four pair of latches in this example, is configured to input the injection signal at the odd phases, namely at P1, P3, P5, P7, P9, P11, P13, and P15, whereby the outputs are taken at the even phases, namely at P0, P2, P4, P6, P8, P10, P12, and P14.

As it can be seen, each ring oscillator of the eight ring oscillators is injection locked with its adjacent ring oscillator.

It is to be noted that the invention is not limited to the number of oscillators and/or the number of stages illustrated in this example. For example, the oscillator device 300 may comprise a number of N coupled oscillators directly coupled in a cascade formation, where N is an even number. Moreover, each of the number of N coupled oscillators may comprise a number of M stages, where M is an odd number.

In this regard, the number of N coupled oscillators may comprise a number of 2*N phases, wherein a number of N/2 input arrangements may be coupled to the odd phases of the number of 2*N phases, and, a number of N/2 output terminals being coupled to the even phases of the number of 2*N phases. Moreover, each of the adjacent phases of the number of 2*N phases being coupled via a capacitor, i.e., a total of 2*N capacitors.

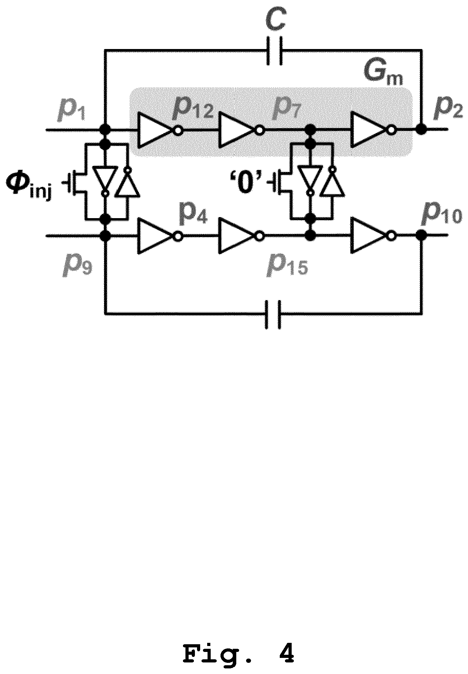

In Fig. 4, an exemplary block of the oscillator device 300 is illustrated, especially comprising part of the first oscillator 101 and the second oscillator 102, and the capacitive element 106. Fig. 4 further shows the injection switches in parallel with latches. For example, the input arrangement 104 provides the injection signal Ø*ᵢₙⱼ* at the phases P1 and P9, and provides the dummy injection "0" (dummy latch) at the phases P7 and P15, e.g., to reduce errors and/or mismatch. Since P2 is the next phase of P1, the capacitor C and the three series inverters between the phases P1 and P2 form negative feedback which behaves as a Gm-C low-pass filter.

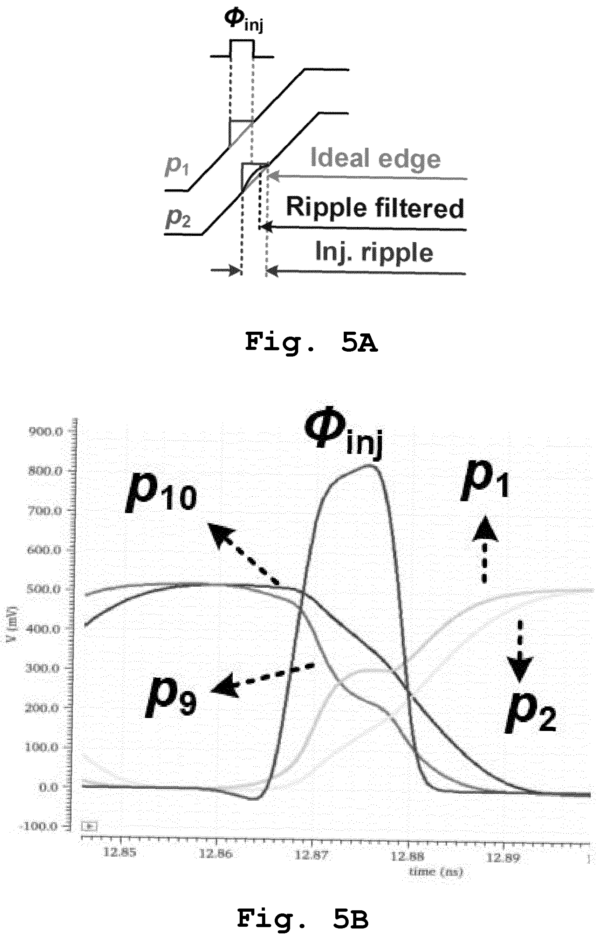

In Fig. 5A and Fig. 5B, exemplary representations of two adjacent phases P1 and P2, the injection ripple, and filtered waveform of the oscillator block of Fig. 4 are illustrated.

In particular, a fundamental issue of a conventional injection-locked ring oscillator can be seen form the representation of P1. Due to the application of the injection signal Ø*ᵢₙⱼ* at the switch of two inverted phases, the shorted nodes cause an abrupt waveform change. This waveform change is translated to a timing error (as shown with dashed lines for injection ripple).

Since the injection signal is periodic, the timing error is periodic as well. Consequently, the oscillator output, in this case P2, is periodically disturbed by the injection, and the injection spurs are observed in the output spectrum.

However, due to the low-pass filtering between the adjacent phases P1 and P2, the timing error at P2 can be effectively filtered, leading to lower injection spurs.

This can also be seen in Fig. 5B, where the phase P2 is "smoother" than the phase P1. Similar effect can be observed between the adjacent phases P9 and P10 (Fig. 4), where the injection is exerted at P9 and the output is taken from P10, which are also coupled via a capacitor.

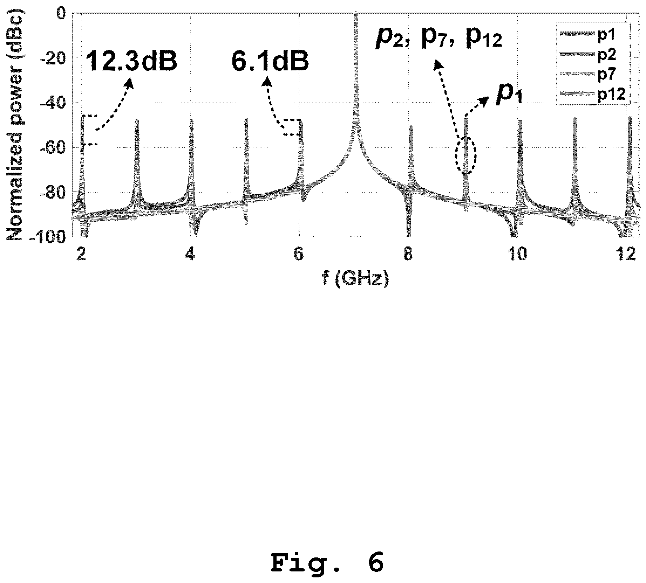

In Fig. 6, simulation results of injection spurs for multiple phases of the oscillator block of Fig. 4 are illustrated. It can be seen that the spurs of P2 at 1 GHz and 5 GHz offsets are lower than that of P1 by 6.1 dB and 12.3 dB, respectively. The filtering takes effect for all the following phases owing to other Gm-C filters. Thus, spurs of P7 and P12 are further reduced. Even though P12 is the inverter's output with P1 as the input, its spur is lower due to the filtering by the previous stages.

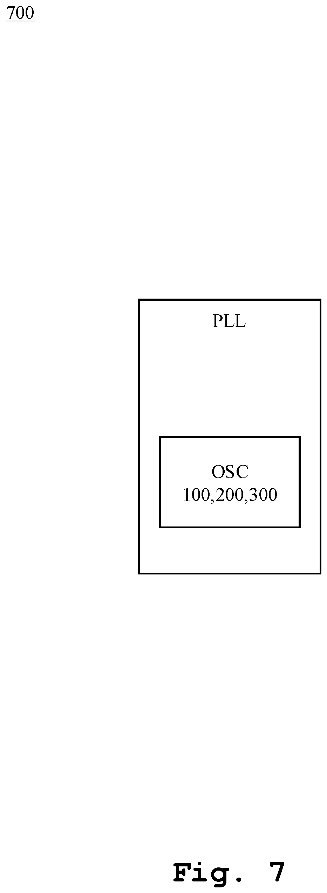

In Fig. 7, an exemplary embodiment of the PLL 700 according to the second aspect of the invention is illustrated. For example, the PLL 700 may be a wideband digital PLL that comprises the oscillator device 100, 200, 300.

Although not shown, the PLL 700 may comprise other building blocks such as the baseband block, e.g., a digital-to-time (DTC) based digital baseband for the clock generation, the filter block, e.g., a digital loop filter preferably with normalization, which are known in the art.

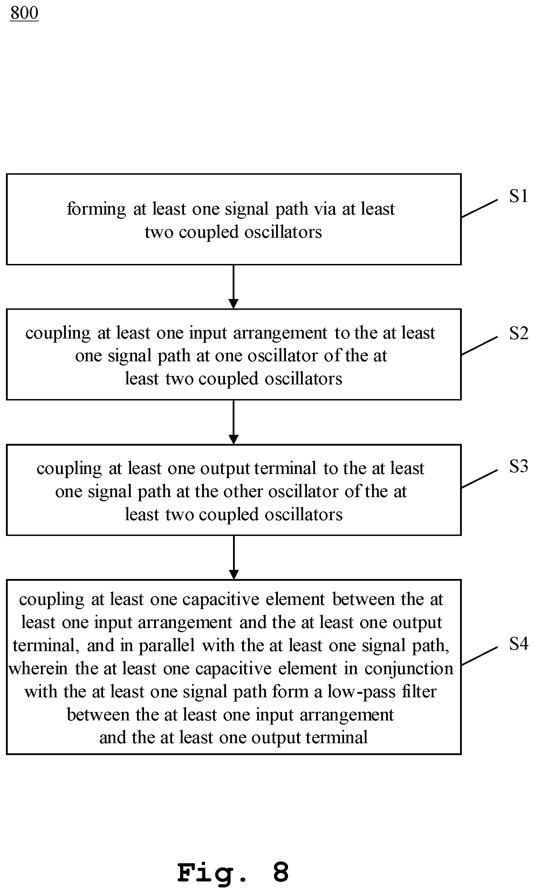

In Fig. 8, an exemplary embodiment of the method 800 according to the second aspect of the invention is illustrated. In a first step S1, at least one signal path is formed via at least two coupled oscillators. In a second step S2, at least one input arrangement is coupled to the at least one signal path at one oscillator of the at least two coupled oscillators.

In a third step S3, at least one output terminal is coupled to the at least one signal path at the other oscillator of the at least two coupled oscillators. In a fourth step S4, at least one capacitive element is coupled between the at least one input arrangement and the at least one output terminal, and in parallel with the at least one signal path.

In this regard, the at least one capacitive element in conjunction with the at least one signal path form a low-pass filter between the at least one input arrangement and the at least one output terminal.

It is important to note that, in the description as well as in the claims, the word "comprising" does not exclude other elements or steps and the indefinite article "a" or "an" does not exclude a plurality. A single element or other unit may fulfill the functions of several entities or items recited in the claims.

It should be understood that the term "and/or" used in the specification and the appended claims of this application refers to any combination and all possible combinations of one or more associated listed items, and includes these combinations.

It should also be understood that the word "coupled" implies that the elements may be directly connected together or may be coupled through one or more intervening elements. Moreover, the disclosure with regard to any of the aspects is also relevant with regard to the other aspects of the disclosure.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. An oscillator device (100, 200, 300) for input injection spur reduction comprising:
at least two coupled oscillators (101, 102) configured to form at least one signal path (103),
at least one input arrangement (104) operably coupled to the at least one signal path (103) at one oscillator (101) of the at least two coupled oscillators (101, 102),
at least one output terminal (105) operably coupled to the at least one signal path (103) at the other oscillator (102) of the at least two coupled oscillators (101, 102), and
at least one capacitive element (106) coupled between the at least one input arrangement (104) and the at least one output terminal (105), and in parallel with the at least one signal path (103),
wherein the at least one capacitive element (106) in conjunction with the at least one signal path (103) being configured to form a low-pass filter between the at least one input arrangement (104) and the at least one output terminal (105).

2. The oscillator device according to claim 1,
wherein the at least one input arrangement (104) is configured to input at least one injection signal for injection locking the at least two coupled oscillators (101, 102).

3. The oscillator device according to claim 2,
wherein the at least one injection signal comprises or is a periodic signal comprising a frequency corresponding to an oscillation frequency of the at least two coupled oscillators (101, 102).

4. The oscillator device according to any of claims 1 to 3,
wherein an input phase (P1) at the at least one input arrangement (104) and an output phase (P2) at the at least one output terminal (105) are adjacent phases of the at least two coupled oscillators (101, 102).

5. The oscillator device according to any of claims 1 to 4,
wherein each oscillator of the at least two coupled oscillators (101, 102) comprises or is a ring oscillator.

6. The oscillator device according to claim 5,
wherein the ring oscillator comprises or is a three-stage ring oscillator.

7. The oscillator device according to any of claims 1 to 6,
wherein the at least one signal path (103) comprises an odd number of inverters (201) in series, preferably three inverters in series.

8. The oscillator device according to claim 7,
wherein the inverters (201) are complementary metal-oxide semiconductor, CMOS, inverters.

9. The oscillator device according to claim 7 or 8, wherein the at least one capacitive element (106) is configured to form the low-pass filter between the at least one input arrangement (104) and the at least one output terminal (105) as a low-pass transconductor-capacitor, Gm-C, filter corresponding to the transconductance (Gm) of the inverters (201) of the at least one signal path (103) and to the capacitance (C) of the at least one capacitive element (106).

10. The oscillator device according to any of claims 1 to 9,
wherein the at least one capacitive element (106) comprises or is a wiring capacitor.

11. The oscillator device according to any of claims 1 to 10,
wherein the oscillator device (300) comprises a number of N coupled oscillators being directly coupled in a cascade formation, where N is an even number.

12. The oscillator device according to claim 10,
wherein the number of N coupled oscillators comprise a number of 2*N phases (P0-P15), wherein a number of N/2 input arrangements being coupled to the odd phases of the number of 2*N phases, and, a number of N/2 output terminals being coupled to the even phases of the number of 2*N phases.

13. The oscillator device according to claim 11 or 12, wherein each of the adjacent phases of the number of 2*N phases (P0-P15) being coupled via the at least one capacitive element.

14. A phase-locked loop (700), PLL, comprising an oscillator device (100, 200, 300) according to any of claims 1 to 13.

15. A method for input injection spur reduction comprising:
forming (S1) at least one signal path via at least two coupled oscillators,
coupling (S2) at least one input arrangement to the at least one signal path at one oscillator of the at least two coupled oscillators,
coupling (S3) at least one output terminal to the at least one signal path at the other oscillator of the at least two coupled oscillators, and
coupling (S4) at least one capacitive element between the at least one input arrangement and the at least one output terminal, and in parallel with the at least one signal path,
wherein the at least one capacitive element in conjunction with the at least one signal path form a low-pass filter between the at least one input arrangement and the at least one output terminal.
